# EUROPÄISCHE PATENTSCHRIFT

(11) **EP 4 504 445 B1**
(45) Veröffentlichungstag und Bekanntmachung des Hinweises auf die Patenterteilung: **28.01.2026**
(21) Anmeldenummer: 23729315.4
(22) Anmeldetag: 17.05.2023
(51) Int. Cl.: B23C 5/10, B23B 27/00, B23B 51/00, B23D 77/00, B23K 26/36, B23K 101/20, B23K 101/34

(54) **VERFAHREN ZUR HERSTELLUNG EINES SCHNEIDWERKZEUGS**
CUTTING TOOL AND METHOD FOR MANUFACTURING A CUTTING TOOL
OUTIL DE COUPE ET PROCÉDÉ DE FABRICATION D'UN OUTIL DE COUPE

(30) Priorität: 17.05.2022 EP 22173898
(43) Veröffentlichungstag der Anmeldung: 12.02.2025
(73) Patentinhaber: Rollomatic S.A., 2525 Le Landeron (CH)
(72) Erfinder: KRUMM, Christian, 2607 Cortébert (CH); MOUREAUX, Carole, 25500 Morteau (FR); SAILLARD, Thibaut, 25000 Besançon (FR)
(74) Vertreter: Geitz Patentanwälte PartG mbB
(86) Internationale Anmeldenummer: PCT/EP2023/063370
(87) Internationale Veröffentlichungsnummer: WO 2023/222822

(56) Entgegenhaltungen:
- EP-A1- 3 674 022
- WO-A1-2018/061355
- JP-A- 2007 307 673
- JP-A- 2016 175 141
- JP-A- H0 811 005
- US-A1- 2021 299 810

## Beschreibung

Die Erfindung geht aus von einem Verfahren zur Herstellung eines Schneidwerkzeugs mit mindestens einer Schneidkante, wobei das Schneidwerkzeug einen Werkzeugkörper aufweist, der mit einer Hartbeschichtung zumindest im Bereich der Schneidkante ausgestattet ist.

Schneidwerkzeuge umfassen Zerspanungswerkzeuge für spanabhebende Fertigungsverfahren und Werkzeuge für das Zerteilen. Sie weisen in der Regel einen Schaft und einen Schneidteil auf. Dabei dient zumindest ein Endabschnitt des Schafts dem Halten des Schneidwerkzeugs, beispielsweise in einer Maschinenschnittstelle bei Maschinenbearbeitungswerkzeugen. An dem Schaft ist der Schneidteil angeordnet. Dieser weist mindestens eine Schneidkante auf, mit der das Schneidwerkzeug in Wechselwirkung mit einem zu bearbeitenden Werkstück tritt und dabei von dem Werkstück Material abträgt. Zu derartigen Schneidwerkzeugen zählen beispielweise Fräser, Bohrer, Reibahlen, Meißel, Schaber, Hobel und Sägen. Dabei kann das Schneidwerkzeug ein Massiv-Werkzeug sein, welches durchgängig aus einem einzigen Material besteht. Alternativ dazu kann das Schneidteil auch einen die Schneidkante umfassenden Einsatz aufweisen, wobei der Einsatz aus einem anderen Material besteht als der Schaft. Schneidwerkzeuge unterliegen an ihrem Einsatzort aufgrund der auf sie wirkenden Kräfte und der entstehenden Temperaturen erheblichen mechanischen und thermischen Belastungen. Hierzu zählen mechanische Reibung, Oxidation und Abrieb sowie vor allem bei hohen Bearbeitungsgeschwindigkeiten Diffusion und Verzunderung. Dies führt zu einem Verschleiß des Schneidwerkzeugs im Bereich der Schneidkante.

Um die Verschleißfestigkeit von Schneidwerkzeugen zu verbessern und die Standzeit zu erhöhen, werden Schneidwerkzeuge im Bereich der Schneidkante mit einer Hartbeschichtung ausgestattet. Diese wird auf den Werkzeugkörper aufgebracht. Zu derartigen Hartbeschichtungen zählen beispielsweise Diamantbeschichtungen, amorphe Kohlenstoffschichten, die in der englischen Sprache als Diamond like Carbon DLC bezeichnet werden, und Titanbeschichtungen. Diese werden beispielsweise mittels chemischer Gasphasenabscheidung, englisch Chemical Vapour Deposition, CVD auf den Werkzeugkörper aufgebracht. Nach dem Abscheiden der Hartbeschichtung weist die beschichtete Schneidkante eine stumpfe Rundung auf. Diese muss anschließend geschärft werden, damit die Schneidkante einen gewünschten Kantenradius aufweist. Hierzu wird ein Teil der Hartbeschichtung im Bereich der Schneidkante abgetragen. Das Schärfen einer Schneidkante durch Abtragen eines Teils des harten Materials an der Oberfläche des Schneidwerkzeugs kann beispielsweise mittels einer Laserbearbeitungsmaschine durchgeführt werden. Der Materialabtrag wird auch als Laserablation oder Laserverdampfen bezeichnet. Das Material kann beispielsweise flächig in Schichten abgetragen werden. Dabei ist der Laserstrahl im wesentlichen senkrecht zu der Fläche ausgerichtet, an der ein Teil der Hartbeschichtung abgetragen wird. Hierbei kann es sich um die Freifläche oder die Spanfläche handeln. Ein derartiges Verfahren ist beispielsweise aus der DE 10 2009 004 316 A1 und aus der DE 10 2011 076 584 A1 bekannt. Ferner besteht die Möglichkeit, ein Teil der Hartbeschichtung mittels kontinuierlicher oder gepulster Laserstrahlung abzutrennen, wobei der Laserstrahl im wesentlichen parallel zu der zu erzeugenden Oberfläche ausgerichtet ist. Ein derartiges Verfahren ist beispielsweise aus der EP 2 682 219 A1 bekannt. Dabei kann der Laserstrahl derart auf das zu bearbeitende Schneidwerkzeug gerichtet werden, dass der Materialabtrag im Bereich der zu erzeugenden Schneidkante beginnt, wie dies in Figur 1 der EP 2 682 219 A1 dargestellt ist. Dies wird auch als Materialabtrag von vorne bezeichnet. Alternativ dazu kann der Materialabtrag auch an der Seite des Schneidwerkzeugs beginnen, die der zu erzeugenden Schneidkante abgewandt ist, wie dies in Figur 3 der EP 2 682 219 A1 dargestellt ist. Dies wird auch als Materialabtrag von hinten bezeichnet. Die Parameter der Laserstrahlung müssen an das zu bearbeitende Material und die gewünschte Bearbeitung angepasst werden. Der Materialabtrag kann an der Freifläche, an der Spanfläche oder an beiden Flächen erfolgen. Ein Verfahren nach dem Oberbegriff des Anspruchs 1 ist aus JP 2016 175141 A bekannt.

Das Schärfen der beschichteten Schneidkante erfolgt in der Regel derart, dass der Keilwinkel des durch die Freifläche und die Spanfläche gebildeten Schneidkeils des unbeschichteten Werkzeugkörpers mit dem Keilwinkel des beschichteten und nachgeschärften Schneidkeils übereinstimmt. Dieses Vorgehen weist jedoch den Nachteil auf, dass bei einer Ausrichtung des Laserstrahls parallel zu der zu erzeugenden Oberfläche und einem Materialabtrag von hinten der Laserstrahl in unerwünschter Weise an einer sekundären Freifläche oder einer sonstigen Oberfläche des Schneidwerkzeugs abgelenkt werden kann, die weder der Freifläche noch der Spanfläche entspricht. Eine derartige Ablenkung des Laserstrahls kann dazu führen, dass die Laserbearbeitung nicht zu dem angestrebten Schärfen der Schneidkante führt.

Der Erfindung liegt die Aufgabe zugrunde, ein Verfahren zur Herstellung eines hartbeschichteten Schneidwerkzeugs zur Verfügung zu stellen, bei dem ein vorgegebener Kantenradius der beschichteten Schneidkante auch dann in zuverlässiger Weise erzielt werden kann, wenn zum Schärfen der beschichteten Schneidkante ein Teil der Hartbeschichtung mittels eines Laserstrahls abgetragen wird, wobei der Laserstrahl nicht senkrecht zu der zu erzeugenden Oberfläche des Schneidwerkzeugs ausgerichtet ist und der Materialabtrag auch von hinten erfolgen kann.

Diese Aufgabe wird durch ein Verfahren zur Herstellung eines Schneidwerkzeugs mit den Merkmalen des Anspruchs 1 gelöst. Das Verfahren zeichnet sich dadurch aus, dass die Oberfläche der Hartbeschichtung im Bereich der Freifläche nach dem teilweisen Materialabtrag nicht parallel zu der darunterliegenden Oberfläche des Werkzeugkörpers ist, sondern dass eine erste geometrische Ebene, in welcher die unter der Hartbeschichtung der Freifläche liegende Oberfläche des Werkzeugkörpers verläuft, und eine zweite geometrische Ebene, in welcher eine durch die geschärfte Schneidkante begrenzte Oberfläche der Hartbeschichtung im Bereich der Freifläche nach Abschluss des Materialabtrags verläuft, einen Winkel δ einschließen, für den gilt: 2° ≤ δ ≤ 10°.

Dabei wird berücksichtigt, dass die unter der Beschichtung an der Freifläche liegende Oberfläche des Werkzeugkörpers an der unbeschichteten Schneidkante endet, während sich die geometrische Ebene, in der diese Oberfläche des Werkzeugkörpers verläuft, unendlich weit erstreckt. Die Oberfläche der Hartbeschichtung im Bereich der Freifläche nach dem teilweisen Materialabtrag endet an der geschärften Schneidkante, während sich die zweite geometrische Ebene unendlich weit erstreckt. Die erste geometrische Ebene und die zweite geometrische Ebene schneiden sich entlang einer geometrischen Geraden. Diese geometrische Gerade kann
- mit der unbeschichteten Schneidkante des Werkzeugkörpers zusammenfallen,
- mit der geschärften Schneidkante des Schneidwerkzeugs zusammenfallen,
- außerhalb des Werkzeugkörpers und innerhalb der Hartbeschichtung an der Spanfläche verlaufen, oder
- außerhalb des Schneidwerkzeugs verlaufen.

Die Oberfläche der Hartbeschichtung im Bereich der Freifläche ist bevorzugt nach Abschluss des Materialabtrags derart geneigt, dass die Schichtdicke der Hartbeschichtung an der Freifläche ausgehend von der Schneidkante mit zunehmender Entfernung von der Schneidkante zunimmt. Wenn eine Hartbeschichtung mit einheitlicher Schichtdicke an der Schneidkante, der Freifläche und der Spanfläche abgeschieden wird, muss beim anschließenden Nachschärfen der Schneidkante nur unmittelbar an der Schneidkante ein gewisser Materialabtrag erfolgen. Die Menge des abzutragenden Materials der Hartbeschichtung nimmt mit zunehmender Entfernung von der Schneidkante ab. Dadurch wird eine Schneidkante mit vorgegebenem Kantenradius erzeugt und es verbleibt gleichzeitig mehr Material der Hartbeschichtung an dem Schneidwerkzeug. Da weniger Material entfernt werden muss, erfolgt der Materialabtrag in einer kürzeren Zeit.

Das Schneidwerkzeug kann länglich sein und sich entlang einer geometrischen Längsachse erstrecken. Hierzu zählen beispielsweise Fräser oder Bohrer. Die mindestens eine Schneidkante kann eine Hauptschneide oder eine Nebenschneide sein. Sie kann sich an einer Stirnseite des länglichen Schneidwerkzeugs befinden oder sich entlang des Schafts im Bereich einer Spannut erstrecken.

Der Materialabtrag der Hartbeschichtung erfolgt mittels Laserbearbeitung. Hierzu wird ein Laserstrahl einer Laserbearbeitungsmaschine relativ zu der Oberfläche der Hartbeschichtung an der Freifläche unter einem bestimmten Winkel ausgerichtet, um die Hartbeschichtung teilweise zu entfernen. Dabei hängt der Winkel, unter dem der Laserstrahl mit seiner geometrischen Strahlachse relativ zu der Oberfläche des beschichteten Schneidwerkzeugs ausgerichtet wird, von dem Winkel δ ab, den die erste geometrische Ebene und die zweite geometrische Ebene nach Abschluss des Materialabtrags einschließen. Nach einer ersten Alternative der Erfindung ist der Laserstrahl derart ausgerichtet, dass die geometrische Strahlachse parallel oder tangential zu der zu erzeugenden Oberfläche an der Freifläche verläuft. Da der Laserstrahl in der Regel auf die Oberfläche des Schneidwerkzeugs fokussiert ist, wird bei der Ausrichtung des Laserstrahls nach einer zweiten Alternative der Erfindung der Öffnungswinkel des Laserstrahls berücksichtigt. Wenn die Hartbeschichtung nach dem Schichtauftrag im Bereich der Freifläche eine einheitliche Schichtdicke aufweist, kann der Laserstrahl mit seiner geometrischen Strahlachse zu Beginn des Materialabtrags unter dem Winkel δ relativ zu der zu erzeugenden Oberfläche ausgerichtet werden. Wenn der Öffnungswinkel des fokussierten Laserstrahls berücksichtigt wird, entspricht der Winkel der Summe aus dem halben Öffnungswinkel und dem Winkel δ. Der Abtrag der Hartbeschichtung kann dabei insbesondere von hinten erfolgen. Das heißt, dass der Abtrag in einem der zu erzeugenden scharfen Schneidkante abgewandten Abschnitt der Freifläche beginnt. Dadurch wird eine unerwünschte Ablenkung des Laserstrahls vermieden. Ferner wird sichergestellt, dass die Stellen, an denen der Laserstrahl auf das Schneidwerkzeug auftrifft, alle während des Materialabtrags entfernt werden. Die erzeugte Oberfläche an der Freifläche ist daher glatt. Sie weist eine gute Oberflächenqualität auf. Es wird eine geschärfte Schneidkante mit einem vorgegebenen Kantenradius in der gewünschten Qualität erzeugt.

Nach einer vorteilhaften Ausgestaltung der Erfindung wird auf dem Werkzeugkörper eine Hartbeschichtung mit einer Schichtdicke zwischen 2 µm und 40 µm abgeschieden.

Nach einer weiteren vorteilhaften Ausgestaltung der Erfindung erfolgt das Abtragen der Hartbeschichtung derart, dass für den Winkel δ gilt: 3° ≤ δ ≤ 6°. Der Winkel δ hängt typischerweise von der Schichtdicke der Hartbeschichtung an der Freifläche, vom Material der Hartbeschichtung und von dem Keilwinkel des Schneidkeils ab.

Nach einer weiteren vorteilhaften Ausgestaltung der Erfindung wird bei dem teilweisen Abtrag der Hartbeschichtung die Dicke der Hartbeschichtung an der Freifläche derart reduziert, dass die Dicke der Hartbeschichtung an der Freifläche ausgehend von der geschärften Schneidkante mit zunehmender Entfernung von der geschärften Schneidkante zunimmt.

Nach einer weiteren vorteilhaften Ausgestaltung der Erfindung schneiden sich die erste geometrische Ebene und die zweite geometrische Ebene an der unbeschichteten Schneidkante. In diesem Fall ist der Werkzeugkörper im Bereich der unbeschichteten Schneidkante von der Hartbeschichtung befreit. Hierdurch können mechanische oder thermische Spannungen zwischen dem Werkzeugkörper und der Hartbeschichtung vermieden werden.

Nach der zweiten Alternative der Erfindung wird bei der Laserbearbeitung der Laserstrahl mit seiner Strahlachse derart ausgerichtet, dass er mit der ersten geometrischen Ebene den Winkel α + δ einschließt, wobei gilt 1° ≤ α ≤ 10°. Dabei wird berücksichtigt, dass der Laserstrahl auf die Oberfläche des Werkstücks fokussiert sein kann und daher einen Öffnungswinkel aufweist. Hierbei entspricht der Winkel α dem halben Öffnungswinkel des Laserstrahls.

Nach einer weiteren vorteilhaften Ausgestaltung der Erfindung beginnt der Materialabtrag der Hartbeschichtung an der Freifläche der Hartbeschichtung in einem der Schneidkante entfernten Abschnitt der Freifläche und endet an der Spanfläche. Es findet in diesem Fall ein Materialabtrag von hinten statt.

Nach einer weiteren vorteilhaften Ausgestaltung der Erfindung wird die mit der Hartbeschichtung ausgestattete Schneidkante durch zusätzliches teilweises Abtragen der Hartbeschichtung im Bereich der Spanfläche geschärft, derart, dass nach dem teilweisen Abtragen der Hartbeschichtung für einen Winkel ε zwischen einer dritten geometrischen Ebene, in welcher die unter der Hartbeschichtung der Spanfläche liegende Oberfläche des Werkzeugkörpers verläuft, und einer vierten geometrischen Ebene, in welcher die durch die geschärfte Schneidkante begrenzte Oberfläche der Hartbeschichtung im Bereich der Spanfläche nach dem teilweisen Materialabtrag verläuft, gilt: 0° ≤ ε ≤ 70°. Dabei kann der Winkel δ mit dem Winkel ε hinsichtlich der Größe übereinstimmen oder von diesem verschieden sein. In diesem Fall wird zum Nachschärfen der Schneidkante nach dem Abscheiden der Hartbeschichtung nicht nur die Schichtdicke der Hartbeschichtung an der Freifläche reduziert, sondern auch an der Spanfläche. Dabei kann der Materialabtrag derart erfolgen, dass die nach dem Materialabtrag neu gebildete Oberfläche parallel zu der darunter liegenden Oberfläche des Werkzeugkörpers ist, also ε=0°, oder mit dieser Oberfläche einen von 0° verschiedenen Winkel einschließt. Ist letzteres erfüllt, so wird genau wie an der Freifläche die Schichtdicke an der Spanfläche bevorzugt derart reduziert, dass die Schichtdicke der Hartbeschichtung ausgehend von der Schneidkante mit zunehmendem Abstand von der Schneidkante zunimmt.

Nach einer weiteren vorteilhaften Ausgestaltung der Erfindung erfolgt das Abtragen der Hartbeschichtung an der Spanfläche derart, dass für den Winkel ε gilt: 2° ≤ ε ≤ 10°, besonders bevorzugt 3° ≤ ε ≤ 6°.

Nach einer weiteren vorteilhaften Ausgestaltung der Erfindung wird bei dem teilweisen Abtrag der Hartbeschichtung die Dicke der Hartbeschichtung an der Spanfläche derart reduziert, dass die Dicke der Hartbeschichtung an der Spanfläche ausgehend von der geschärften Schneidkante mit zunehmender Entfernung von der Schneidkante zunimmt.

Nach einer weiteren vorteilhaften Ausgestaltung der Erfindung wird als Hartbeschichtung eine Diamantschicht an dem Werkzeugkörper abgeschieden. Dabei kann es sich um eine kristalline oder polykristalline Diamantschicht handeln. Letztere haben eine heterogene Verteilung der Größe der kristallinen Domänen. Anstelle von Diamant kann auch eine Hartbeschichtung aus DLC, aus einen Nitrid-basierten Material wie beispielsweis Titannitrid, einem sonstigen Titan enthaltenden Material oder einem anderen für eine Hartbeschichtung geeigneten Material auf den Werkzeugkörper aufgetragen werden. Die Abkürzung DLC steht für Diamond like Carbon. Diese Art der Hartbeschichtung wird auch als amorpher Diamant bezeichnet.

Nach einer weiteren vorteilhaften Ausgestaltung der Erfindung wird die Hartbeschichtung an der Freifläche abschnittweise derart vollständig entfernt, dass der Werkzeugkörper in dem betreffenden Abschnitt freigelegt ist. Dies gilt insbesondere für die Schneidkante des Werkzeugkörpers und gegebenenfalls einen hierzu benachbarten Bereich. Der Werkzeugkörper wird an oder nahe der Schneidkante von der Hartbeschichtung befreit. Hierdurch können mechanische oder thermische Spannungen zwischen Werkzeugkörper und Hartbeschichtung vermieden oder zumindest reduziert werden.

Nach einer weiteren vorteilhaften Ausgestaltung der Erfindung wird die Hartbeschichtung an der Spanfläche abschnittsweise derart vollständig entfernt, dass der Werkzeugkörper in dem betreffenden Abschnitt freigelegt ist. Bevorzugt wird der Werkzeugkörper im Bereich der Schneidkante des Werkzeugkörpers freigelegt. Hierdurch können mechanische und/ oder thermische Spannungen zwischen dem Werkzeugkörper reduziert oder vermieden werden.

Nach einer weiteren vorteilhaften Ausgestaltung der Erfindung erfolgt die Laserbearbeitung mit einem gepulsten Laserstrahl, wobei die Pulsdauer zwischen 50ns und 150fs beträgt. Die Bearbeitung mit derart ultrakurzen Laserpulsen hat den Vorteil, dass an der Oberfläche des Werkstücks lokal begrenzt sehr hohe Energiedichten erzeugt und damit Material abgetragen werden kann, ohne dass sich die Wärme in dem Werkstück in unerwünschter Weise ausbreitet.

Nach einer weiteren vorteilhaften Ausgestaltung der Erfindung beträgt die Pulsdauer zwischen 190fs und 10ps.

Nach einer weiteren vorteilhaften Ausgestaltung der Erfindung beträgt die Pulsfrequenz zwischen 100kHz und 1.000kHz.

Nach einer weiteren vorteilhaften Ausgestaltung der Erfindung beträgt die durchschnittliche Laserleistung zwischen 4 und 40W. Bei einer Pulsdauer zwischen 190fs und 10ps, einer Pulsfrequenz zwischen 100kHz und 1.000kHz und einer durchschnittlichen Laserleistung zwischen 4 und 40W kann eine Bearbeitungsgeschwindigkeit bezogen auf CNC-gesteuerte Maschinenachsen einer Laserbearbeitungsvorrichtung zwischen 10mm/min und 40mm/min erreicht werden.

Nach einer weiteren vorteilhaften Ausgestaltung der Erfindung beträgt die Pulsdauer zwischen 6ns und 45ns und die Pulsfrequenz zwischen 15kHz und 200kHz. In diesem Fall beträgt die durchschnittliche Laserleistung bevorzugt zwischen 9 und 18W. Dabei kann beispielsweise eine Bearbeitungsgeschwindigkeit bezogen auf CNC-gesteuerte Maschinenachsen einer Laserbearbeitungsvorrichtung zwischen 45 mm/min und 100 mm/min erreicht werden.

Nach einer weiteren vorteilhaften Ausgestaltung der Erfindung beträgt der Strahldurchmesser des Laserstrahls im Fokus zwischen 7µm und 25µm. Der Fokus befindet sich bevorzugt an oder nahe der zu bearbeitenden Oberfläche des Werkstücks.

Nach einer weiteren vorteilhaften Ausgestaltung der Erfindung besteht der Werkzeugkörper aus Karbid.

Nach einer weiteren vorteilhaften Ausgestaltung der Erfindung beträgt die Schichtdicke der Hartbeschichtung im Bereich der Freifläche und der Spanfläche der Schneidkante, in der kein Materialabtrag erfolgt, zwischen 2 und 40µm.

Weitere Vorteile und vorteilhafte Ausgestaltungen der Erfindung sind der nachfolgenden Beschreibung, der Zeichnung und den Ansprüchen entnehmbar.

### Zeichnung

In der Zeichnung sind Ausführungsbeispiele der Erfindung dargestellt. Es zeigen:
- Figur 1: Schneidwerkzeug ohne Hartbeschichtung in perspektivischer Darstellung,
- Figur 2: Ausschnitt aus dem Schneidwerkzeug gemäß Figur 1,
- Figur 3: Schneidwerkzeug gemäß Figur 1 in perspektivischer Darstellung unmittelbar nach dem Auftrag einer Hartbeschichtung und vor dem Schärfen der Schneidkante,
- Figur 4: Ausschnitt aus dem Schneidwerkzeug gemäß Figur 3,
- Figur 5: Schnitt durch das Schneidwerkzeug gemäß Figur 3 im Bereich einer Schneidkante an der Stirnseite,
- Figur 6: Schnitt gemäß Figur 5, wobei die Hartbeschichtung an der Freifläche der Schneidkante teilweise entfernt ist,
- Figur 7: Darstellung gemäß Figur 6 mit dem Winkel δ,
- Figur 8: Darstellung gemäß Figur 7 mit einem Winkel α,
- Figur 9: Schnitt durch das Schneidwerkzeug gemäß Figur 3 und 5, wobei die Hartbeschichtung an der Freifläche und an der Spanfläche der Schneidkante teilweise entfernt ist,
- Figur 10: Schnitt durch das Schneidwerkzeug gemäß Figur 3 und 5, wobei die Hartbeschichtung an der Freifläche und in einer von Figur 9 abweichenden Art an der Spanfläche der Schneidkante teilweise entfernt ist,
- Figur 11: Schneidwerkzeug gemäß Figur 3, wobei die Hartbeschichtung an der Freifläche und an der Spanfläche der Schneidkante gemäß Figur 9 entfernt ist,
- Figur 12: Ausschnitt aus dem Schneidwerkzeug gemäß Figur 11,
- Figur 13: Darstellung der Ausrichtungen eines Laserstrahls beim Materialabtrag bei dem Schneidwerkzeug gemäß Figuren 6 bis 12, wobei der Materialabtrag im Bereich einer Schneidkante an der Stirnseite des Schneidwerkzeugs erfolgt,
- Figur 14: weitere Schneidkante des Schneidwerkzeugs gemäß Figur 3,
- Figur 15: Darstellung einer Ausrichtung des Laserstrahls beim Materialabtrag bei dem Schneidwerkzeug gemäß Figuren 6 bis 12 an einer Freifläche einer Schneidkante im Bereich der Spannut,
- Figur 16: Darstellung einer Ausrichtung des Laserstrahls beim Materialabtrag bei dem Schneidwerkzeug gemäß Figuren 6 bis 12 an einer Spanfläche einer Schneidkante im Bereich der Spannut, Beginn des Materialabtrags,
- Figur 17: fortschreitender Materialabtrag gemäß Figur 16 an der Spanfläche im Bereich der Schneidkante der Spannut.

### Beschreibung der Ausführungsbeispiele

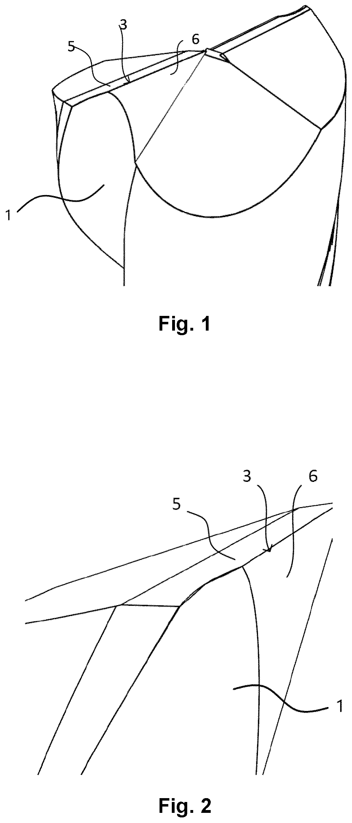

In den Figuren 1 bis 10 ist der Kopf eines Schneidwerkzeugs zu verschiedenen Zeitpunkten seiner Herstellung dargestellt. Bei dem Schneidwerkzeug handelt es sich um einen Vierkant-Schaftfräser. Figuren 1 und 2 zeigen den Kopf des Werkzeugkörpers 1 des Schneidwerkzeugs ohne Hartbeschichtung. Der Werkzeugkörper weist an seiner Stirnseite eine Schneidkante 3 mit einer zugehörige Freifläche 5 und einer zugehörigen Spanfläche 6 auf.

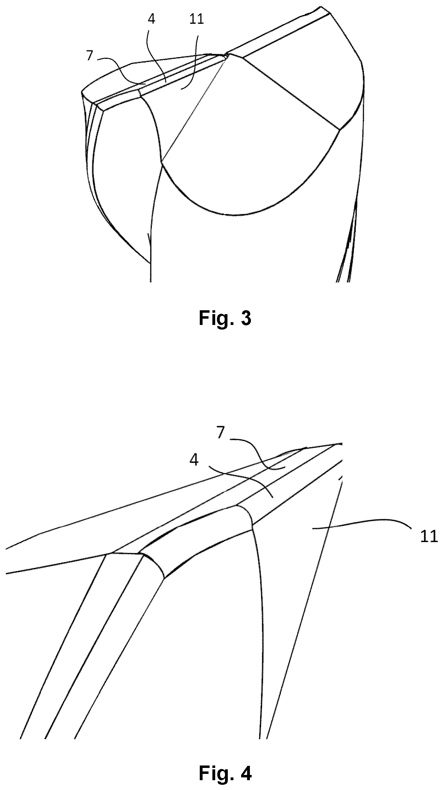

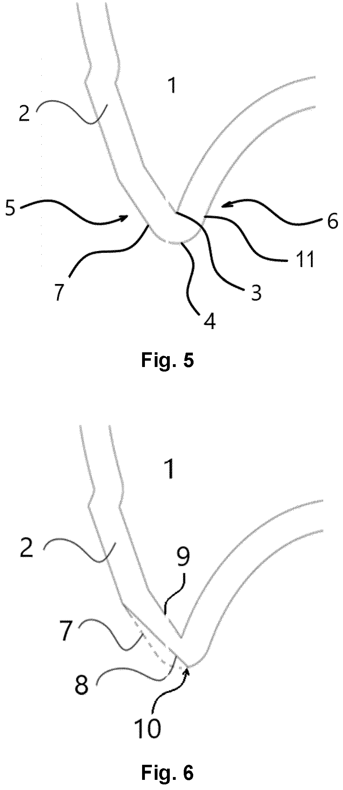

Die Figuren 3, 4 und 5 zeigen das Schneidwerkzeug nach dem Auftrag einer Hartbeschichtung 2 auf den Werkzeugkörper 1. Die Hartbeschichtung erstreckt sich über die gesamte in Figur 1 dargestellte Oberfläche des Werkzeugkörpers 1. Durch den Auftrag der Hartbeschichtung hat sich über der unbeschichteten Schneidkante 3 des Werkzeugkörpers 1 eine stumpfe Rundung 4 ausgebildet. Benachbart zu der stumpfen Rundung 4 befinden sich die Oberfläche 7 der Hartbeschichtung 2 an der Freifläche 5 und die Oberfläche 11 der Hartbeschichtung an der Spanfläche 6. Die Hartbeschichtung 2 weist in dem in Figur 5 dargestellten Abschnitt eine gleichmäßige Schichtdicke auf.

Figur 5 zeigt, dass der Kantenradius der stumpfen Rundung 4 größer ist als der Kantenradius der Schneidkante 3 des unbeschichteten Werkzeugkörpers 1. Um den Kantenradius der beschichteten Schneidkante zu reduzieren, wird die Schneidkante nach dem Beschichten geschärft, indem die Hartbeschichtung 2 teilweise abgetragen wird.

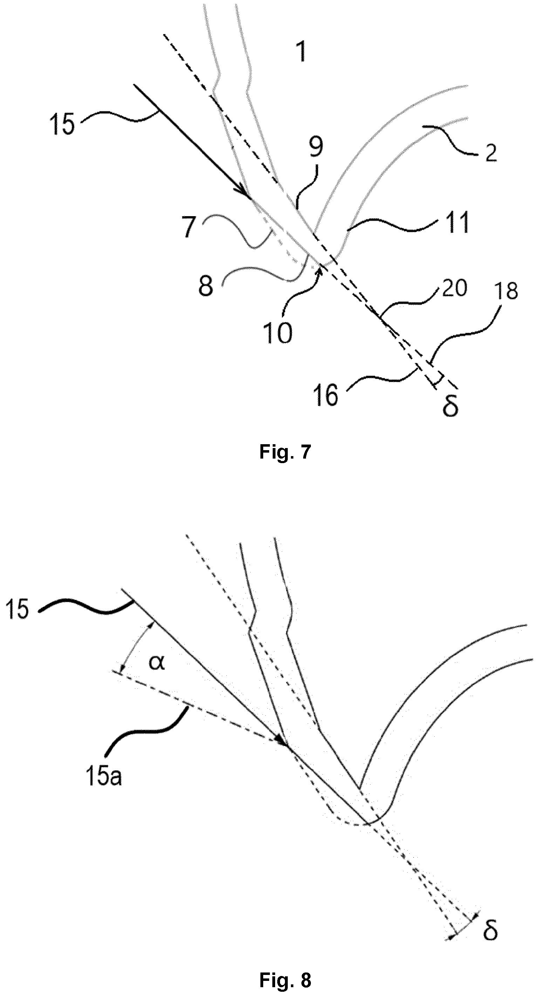

Der Abtrag der Hartbeschichtung ist in den Figuren 6 bis 10 dargestellt. Zuerst wird, wie in Figur 6 und 7 gezeigt, ein Teil der Hartbeschichtung an der Freifläche entfernt, während die Spanfläche zunächst noch unverändert ist. Hierzu wird ein Laserstrahl mit seiner geometrischen Strahlachse 15 derart ausgerichtet, dass die Strahlachse mit einer ersten geometrischen Ebene 16 den Winkel δ einschließt. In dieser ersten geometrischen Ebene 16 verläuft die Oberfläche 9 des Werkzeugkörpers 1 unter der Hartbeschichtung an der Freifläche 5. Diese Oberfläche 9 des Werkzeugkörpers 1 wird durch die Schneidkante 3 des unbeschichteten Werkzeugkörpers 1 begrenzt. Sie ist benachbart zu der Beschichtung 2. Die erste geometrische Ebene ist nicht begrenzt. Sie erstreckt sich über die Oberfläche 9 der Werkzeugkörpers 1 hinaus. Der ursprüngliche Verlauf 7 der Oberfläche der Hartbeschichtung 2 an der Freifläche ist gestrichelt dargestellt. Durch den teilweisen Materialabtrag ist eine neue Oberfläche 8 der Hartbeschichtung an der Freifläche entstanden. Diese Oberfläche 8 verläuft in einer zweiten geometrischen Ebene 18. Die erste geometrische Ebene 16 und die zweite geometrische Ebene 18 sind nicht parallel einander. Sie schneiden sich in einer geometrischen Geraden 20, von der aufgrund der Blickrichtung in Figur 7 nur ein Punkt erkennbar ist. Die geometrische Gerade 20 verläuft außerhalb des Schneidwerkzeugs. Die erste geometrische Ebene 16 und die zweite geometrische Ebene 18 schließen den Winkel δ ein. Im vorliegenden Ausführungsbeispiel beträgt der Winkel δ 10°. Der Winkel δ ist in Figur 7 dargestellt. Durch den teilweisen Materialabtrag an der Freifläche entsteht eine neue geschärfte Schneidkante 10. Figur 7 zeigt, dass der Laserstrahl mit seiner Strahlachse 15 im wesentlichen parallel bzw. tangential zu der zweiten geometrischen Ebene 18 ausgerichtet ist, in der die durch Materialabtrag an der Freifläche erzeugte Oberfläche 8 der Hartbeschichtung verläuft. Figur 7 zeigt ferner, dass der Materialabtrag in einem der Schneidkante abgewandten Abschnitt der Freifläche beginnt und sich entlang der zweiten geometrischen Ebene 18 bis zur Spanfläche fortsetzt.

Figur 8 zeigt eine Alternative zu der Ausrichtung der Strahlachse 15 des Laserstrahls gemäß Figur 7. Der Laserstrahl ist mit seiner Strahlachse 15a gegenüber der Ausrichtung 15 um einen Winkel α geneigt, wobei der Winkel α dem halben Öffnungswinkel des Laserstrahls entspricht. α hat typischerweise einen Wert zwischen 1° und 10°.

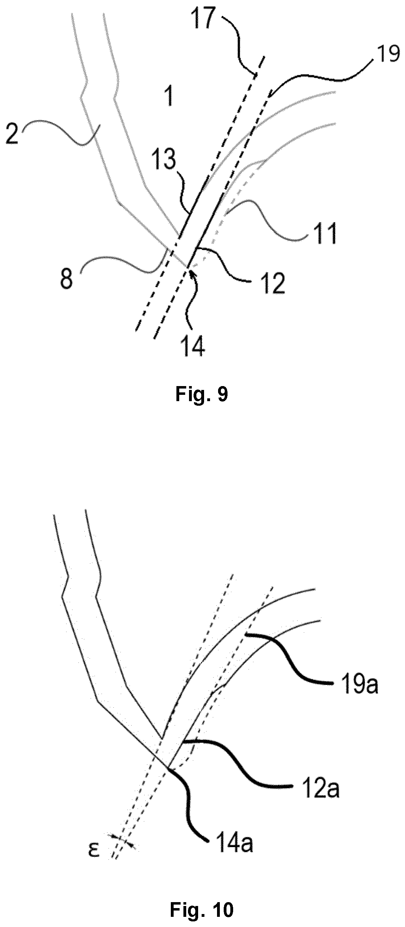

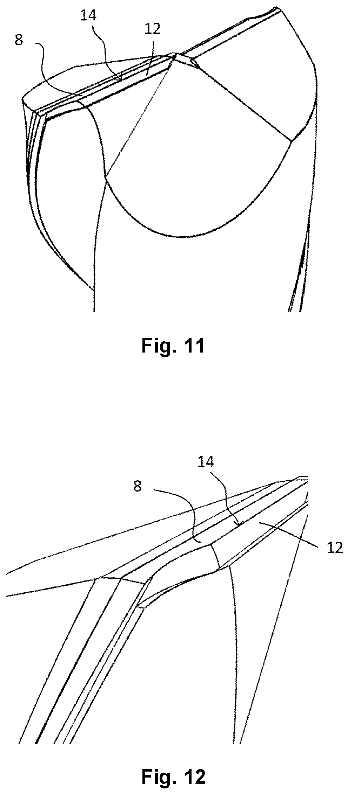

Die Figuren 9, 10, 11 und 12 zeigen das Schneidwerkzeug, nachdem zusätzlich an der Spanfläche ein Teil der Hartbeschichtung 2 entfernt wurde. Der ursprüngliche Verlauf 11 der Oberfläche der Hartbeschichtung an der Spanfläche ist in Figur 9 gestrichelt dargestellt. Durch den teilweisen Materialabtrag ist eine neue Oberfläche 12 der Hartbeschichtung an der Spanfläche entstanden. Diese Oberfläche 12 ist parallel zu der darunter liegenden Oberfläche 13 des Werkzeugkörpers 1. Die Oberfläche 13 verläuft in einer dritten geometrischen Ebene 17. Die Oberfläche 12 verläuft in einer vierten geometrischen Ebene 19. Der Winkel ε zwischen den beiden Oberflächen 12 und 13 ist dabei 0°. Entsprechend ist der Winkel ε zwischen der dritten geometrischen Ebene 17 und der vierten geometrischen Ebene 19 ebenfalls 0°. Die dritte geometrische Ebene 17 und die vierte geometrische Ebene schneiden sich nicht. Durch den teilweisen Materialabtrag an der Spanfläche ist eine neue geschärfte Schneidkante 14 entstanden.

Figur 10 zeigt eine Alternative zu Figur 9. Dabei wird an der Spanfläche derart Material entfernt, dass der Winkel ε von 0° verschieden ist. Die durch den Materialabtrag erzeugte neue Oberfläche 12a der Hartbeschichtung an der Spanfläche ist nicht parallel zu der darunter liegenden Oberfläche 13 des Werkzeugkörpers 1. Die vierte geometrische Ebene 19a, in der die neue Oberfläche 12a verläuft, schneidet die dritte geometrische Ebene 17 entlang einer Geraden und schließt mit der dritten geometrischen Ebene 17 den Winkel ε = 3° ein. Durch den teilweisen Materialabtrag an der Spanfläche ist eine neue geschärfte Schneidkante 14a entstanden.

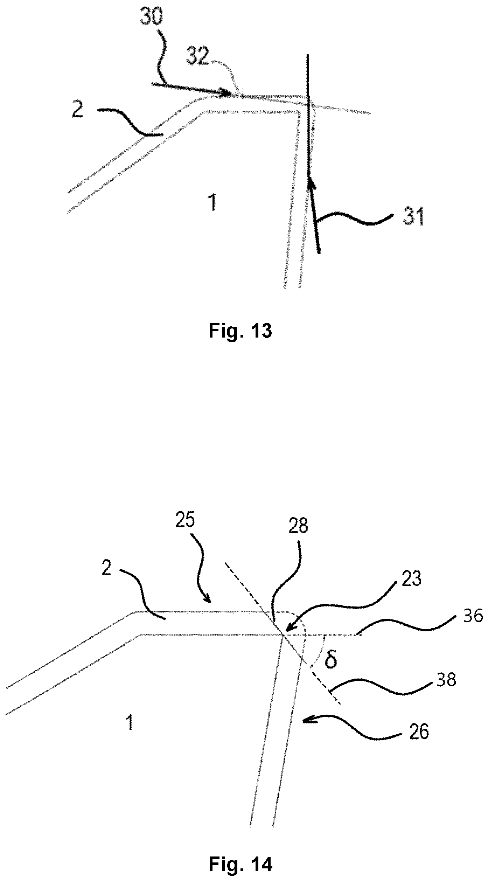

Figur 13 zeigt wie der Laserstrahl mit seiner Strahlachse beim Materialabtrag an der Freifläche und an der Spanfläche ausgerichtet ist, wenn sich die zugehörige Schneidkante im Bereich der Stirnseite des Schneidwerkzeugs befindet. Die erste Ausrichtung der Strahlachse 30 ist beim Materialabtrag an der Freifläche gegeben. Sie entspricht im wesentlichen der Ausrichtung der Strahlachse 15 des Laserstrahls in Figur 7 oder der Ausrichtung der Strahlachse 15a des Laserstrahls in Figur 8. Der Laserstrahl trifft an dem Punkt 32 auf die Oberfläche der Hartbeschichtung 2 des Werkzeugkörpers 1. Der Materialabtrag beginnt in einem der Schneidkante abgewandten Abschnitt der Freifläche und endet an der Spanfläche entlang der geschärften Schneidkante. Der Vorteil dieser Ausrichtung des Laserstrahls besteht darin, dass die Bereiche, auf die der Laserstrahl auftrifft, vollständig entfernt werden. An der am Schneidwerkzeug verbleibenden Hartbeschichtung sind keine Auftreffstellen enthalten. Daher ist die durch den Materialabtrag erzeugte Oberfläche an der Freifläche sehr glatt. Entsprechendes gilt für den Materialabtrag an der Spanfläche: Hier weist die Strahlachse 31 des Laserstrahls ebenfalls eine Ausrichtung auf, die parallel oder tangential zu der zu erzeugenden Oberfläche ist oder mit dieser Oberfläche einen Winkel α zwischen 1° und 10° einschließt. Auf diese Weise kann auch an der Spanfläche eine sehr glatte Oberfläche der Hartbeschichtung erzeugt werden. Der Materialabtrag beginnt in einem der Schneidkante abgewandten Abschnitt der Spanfläche und endet an der Freifläche entlang der geschärften Schneidkante.

Figur 14 zeigt den Materialabtrag an einer weiteren Schneidkante 23 des Schneidwerkzeugs gemäß Figur 3. Dabei wird die Hartbeschichtung 2 an dem Werkzeugkörper 1 ausgehend von der Freifläche 25 derart bis zur Spanfläche 26 abgetragen, dass eine neue Oberfläche 28 der Hartbeschichtung an der Freifläche entsteht. Diese neue Oberfläche 28 verläuft in einer zweiten geometrischen Ebene 38. Die Oberfläche des Werkzeugkörpers 1, welche sich unter der Hartbeschichtung 2 an der Freifläche 25 befindet, verläuft in einer ersten geometrischen Ebene 36. Die erste geometrische Ebene 36 und die zweite geometrische Ebene 38 schneiden sich unter dem Winkel δ in der Schneidkante 23 des Werkzeugkörpers 1. Im vorliegenden Fall ist der Winkel δ 50°. Durch den Materialabtrag und die dabei erzeugte neue Oberfläche 28 wird die Hartbeschichtung an der Schneidkante 23 des Werkzeugkörpers 1 entfernt, so dass die Schneidkante 23 frei von einer Hartbeschichtung ist.

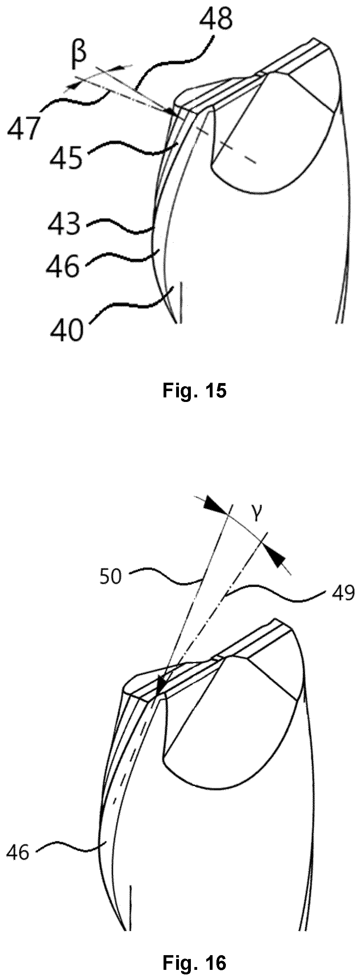

Die Figuren 15, 16 und 17 zeigen den teilweisen Materialabtrag an einer Freifläche und einer Spanfläche entlang einer Spannut 40 des Schneidwerkzeugs gemäß Figuren 1 bis 12. Entlang der Spannut 40 erstreckt sich eine weitere Schneidkante 43 mit einer zugehörige Freifläche 45 und einer zugehörigen Spanfläche 46. Auch diese Schneidkante 43 wird nach dem Auftrag einer Hartbeschichtung durch einen teilweisen Materialabtrag geschärft. Die Spannut 40 ist eine längliche Vertiefung zwischen zwei Schneidkanten, die sich wendelförmig an der Außenseite des Schaftes des Schneidwerkzeugs erstrecken. Von diesen zwei Schneidkanten ist in den Figuren 15 bis 17 nur die Schneidkante 43 sichtbar. Die andere Schneidkante befindet sich auf der dem Betrachter abgewandten Seite des Schneidwerkzeugs. Die Spannut 40 dient zur Aufnahme der abgetrennten Späne während des Schneideneingriffs des Schneidwerkzeugs mit einem in der Zeichnung nicht dargestellten Werkstück.

Figur 15 zeigt dabei, wie der Laserstrahl mit seiner geometrischen Strahlachse 47 ausgerichtet ist, um an der Freifläche 45 Material abzutragen. Dabei schließt die geometrische Strahlachse 47 mit einer Tangente 48 an die zu erzeugende Oberfläche der Freifläche 45 einen Winkel β ein. Dieser entspricht typischerweise dem halben Öffnungswinkel des Laserstrahls. Der Winkel β kann mit dem Winkel α gemäß Figur 8 übereinstimmen. Dies ist jedoch nicht zwingend notwendig. Da sich die Freifläche 45 der Schneidkante 43 an einem nach außen gerichteten Abschnitt des Schneidwerkzeugs befindet, kann der Laserstrahl mit seiner geometrischen Strahlachse 47 in einer Ebene ausgerichtet werden, die im wesentlichen senkrecht zu einer geometrischen Schneidwerkzeug-Längsachse verläuft.

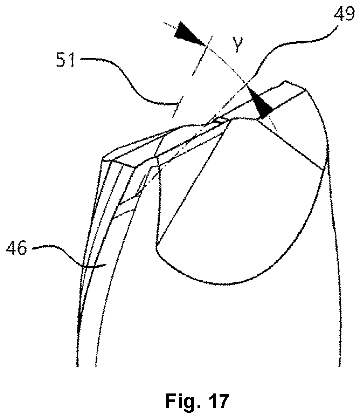

Die Figuren 16 und 17 zeigen, wie der Laserstrahl mit seiner geometrischen Strahlachse 49 ausgerichtet ist, um an der Spanfläche 46 Material abzutragen. Figur 16 zeigt die Ausrichtung der geometrischen Strahlachse zu Beginn des Materialabtrags an der Stirnseite des Schneidwerkzeugs. Figur 17 zeigt die Ausrichtung der geometrischen Strahlachse 49, wenn der Materialabtrag bereits entlang der Spannut 40 in axialer Richtung fortgeschritten ist. Die geometrische Strahlachse 49 ist in beiden Fällen relativ zu einer Tangente 50, 51 an die zu bearbeitenden Oberfläche um einen Winkel γ geneigt. Da sich die Spanfläche 46 an der nach innen gewölbten Oberfläche der Spannut befindet, muss der Laserstrahl mit seiner geometrischen Strahlachse 49 in Abweichung zu der Darstellung gemäß Figur 15 ausgerichtet werden, damit er an der vorgesehenen Position und in tangentialer Richtung auf die Oberfläche des Schneidwerkzeugs trifft.

### Bezugszahlen

- 1: Werkzeugkörper
- 2: Hartbeschichtung
- 3: Schneidkante des Werkzeugkörpers
- 4: Stumpfe Rundung
- 5: Freifläche
- 6: Spanfläche
- 7: Ursprünglicher Verlauf der Oberfläche der Hartbeschichtung an der Freifläche
- 8: Verlauf der Oberfläche der Hartbeschichtung an der Freifläche nach dem teilweisen Materialabtrag
- 9: Oberfläche des Werkzeugkörpers an der Freifläche
- 10: nachgeschärfte beschichtete Schneidkante
- 11: Ursprünglicher Verlauf der Oberfläche der Hartbeschichtung an der Spanfläche
- 12: Verlauf der Oberfläche der Hartbeschichtung an der Spanfläche nach dem teilweisen Materialabtrag
- 12a: Verlauf der Oberfläche der Hartbeschichtung an der Spanfläche nach dem teilweisen Materialabtrag in einer Alternative
- 13: Oberfläche des Werkzeugkörpers an der Spanfläche
- 14: nachgeschärfte beschichtete Schneidkante
- 14a: nachgeschärfte beschichtete Schneidkante in einer Alternative
- 15: geometrische Strahlachse eines Laserstrahls
- 15a: geometrische Strahlachse des Laserstrahls
- 16: erste geometrische Ebene
- 17: dritte geometrische Ebene
- 18: zweite geometrische Ebene
- 19: vierte geometrische Ebene
- 19a: vierte geometrische Ebene in einer Alternative
- 20: geometrische Gerade, in der sich die erste und die zweite geometrische Ebene schneiden
- 23: Schneidkante des Werkzeugkörpers
- 25: Freifläche
- 26: Spanfläche
- 28: Verlauf der Oberfläche der Hartbeschichtung an der Freifläche nach dem teilweisen Materialabtrag
- 30: erste Ausrichtung der Strahlachse des Laserstrahls
- 31: zweite Ausrichtung der Strahlachse des Laserstrahls
- 32: Auftreffpunkt des Laserstrahls auf die Oberfläche der Hartbeschichtung
- 36: erste geometrische Ebene
- 38: zweite geometrische Ebene
- 40: Spannut
- 43: Schneidkante
- 45: Freifläche
- 46: Spanfläche
- 47: geometrische Strahlachse des Laserstrahls
- 48: Tangente an die zu bearbeitenden Oberfläche der Freifläche
- 49: geometrische Strahlachse des Laserstrahls
- 50: Tangente an die zu bearbeitenden Oberfläche der Freifläche
- 51: Tangente an die zu bearbeitenden Oberfläche der Freifläche

## Patentansprüche

1. Verfahren zur Herstellung eines Schneidwerkzeugs, welches einen Werkzeugkörper mit einer Hartbeschichtung aufweist, wobei die Hartbeschichtung (2) zumindest im Bereich einer Schneidkante (3), einer Freifläche (5) und einer Spanfläche (6) auf den Werkzeugkörper (1) aufgebracht ist, mit den Verfahrensschritten: Abscheiden einer Hartbeschichtung (2) an der Oberfläche des Werkzeugkörpers (1) des Schneidwerkzeugs im Bereich der Schneidkante (3), einer zur Schneidkante (3) benachbarten Freifläche (5) und einer zur Schneidkante (3) benachbarten Spanfläche (6), und Schärfen der mit der Hartbeschichtung (2) ausgestatteten, eine stumpfe Rundung (4) bildenden Schneidkante durch teilweises Abtragen der Hartbeschichtung (2) im Bereich der Freifläche (5) der Schneidkante mittels Laserbearbeitung, **dadurch gekennzeichnet, dass** das Abtragen der Hartbeschichtung (2) derart erfolgt, dass für einen Winkel δ zwischen einer ersten geometrischen Ebene , in welcher die unter der Hartbeschichtung (2) der Freifläche (5) liegende Oberfläche (9) des Werkzeugkörpers (1) verläuft, und einer zweiten geometrischen Ebene (18), in welcher eine durch die geschärfte Schneidkante (10, 14, 14a) begrenzte Oberfläche (8) der Hartbeschichtung (2) im Bereich der Freifläche (5) nach dem Abtragen verläuft, gilt: 2° ≤ δ ≤ 10°, bevorzugt 3° ≤ δ ≤ 6°, und dass bei der Laserbearbeitung ein Laserstrahl mit seiner geometrischen Strahlachse (15, 15a, 30) derart ausgerichtet wird, dass die geometrische Strahlachse mit der ersten geometrischen Ebene (16) den Winkel δ oder einen Winkel α + δ einschließt, wobei gilt 1° ≤ α ≤ 10°.

2. Verfahren nach Anspruch 1, **dadurch gekennzeichnet, dass** auf dem Werkzeugkörper (1) eine Hartbeschichtung (2) mit einer Schichtdicke zwischen 2 µm und 40 µm abgeschieden wird.

3. Verfahren nach einem der vorhergehenden Ansprüche, **dadurch gekennzeichnet, dass** bei dem teilweisen Abtrag der Hartbeschichtung (2) die Dicke der Hartbeschichtung (2) an der Freifläche (5) derart reduziert wird, dass die Dicke der Hartbeschichtung (2) ausgehend von der geschärften Schneidkante (10, 14, 14a) mit zunehmender Entfernung von der geschärften Schneidkante (10, 14, 14a) zunimmt.

4. Verfahren nach einem der vorhergehenden Ansprüche, **dadurch gekennzeichnet, dass** der Materialabtrag der Hartbeschichtung (2) an der Freifläche (5) der Hartbeschichtung (2) in einem der Schneidkante (3) des Werkzeugkörpers (1) entfernten Abschnitt der Freifläche (5) beginnt und an der Spanfläche (6) endet.

5. Verfahren nach einem der vorhergehenden Ansprüche, **dadurch gekennzeichnet, dass** die mit der Hartbeschichtung (2) ausgestattete Schneidkante (10, 14, 14a) durch zusätzliches teilweises Abtragen der Hartbeschichtung (2) im Bereich der Spanfläche (6) mittels Laserbearbeitung geschärft wird, derart, dass nach dem teilweisen Abtragen der Hartbeschichtung (2) für einen Winkel ε zwischen einer dritten geometrischen Ebene (17), in welcher die unter der Hartbeschichtung (2) der Spanfläche (6) liegende Oberfläche (9) des Werkzeugkörpers (1) verläuft, und einer vierten Ebene (19), in welcher eine durch die geschärfte Schneidkante (14) begrenzten Oberfläche (12) der Hartbeschichtung (2) im Bereich der Spanfläche (6) nach dem Abtragen verläuft, gilt: 0° ≤ ε ≤ 70°.

6. Verfahren nach Anspruch 5, **dadurch gekennzeichnet, dass** das Abtragen der Hartbeschichtung (2) derart erfolgt, dass für den Winkel ε gilt: 2° ≤ ε ≤ 10°, besonders bevorzugt 3° ≤ ε ≤ 6°.

7. Verfahren nach Anspruch 5 oder 6, **dadurch gekennzeichnet, dass** bei dem teilweisen Abtrag der Hartbeschichtung (2) die Dicke der Hartbeschichtung (2) an der Spanfläche (6) derart reduziert wird, dass die Dicke der Hartbeschichtung (2) an der Spanfläche (6) ausgehend von der geschärften Schneidkante (14) mit zunehmender Entfernung von der geschärften Schneidkante (14) zunimmt.

8. Verfahren nach einem der vorhergehenden Ansprüche, **dadurch gekennzeichnet, dass** als Hartbeschichtung (2) eine Diamantschicht an dem Werkzeugkörper (1) abgeschieden wird.

9. Verfahren nach einem der vorhergehenden Ansprüche, **dadurch gekennzeichnet, dass** die Hartbeschichtung (2) an der Freifläche (5) abschnittweise derart vollständig entfernt wird, dass der Werkzeugkörper (1) in dem betreffenden Abschnitt freigelegt ist.

10. Verfahren nach einem der vorhergehenden Ansprüche, **dadurch gekennzeichnet, dass** die Hartbeschichtung (2) an der Spanfläche (6) abschnittsweise derart vollständig entfernt wird, dass der Werkzeugkörper (1) in dem betreffenden Abschnitt freigelegt ist.

11. Verfahren nach einem der vorhergehenden Ansprüche, **dadurch gekennzeichnet, dass** die Laserbearbeitung mit einem gepulsten Laserstrahl erfolgt, wobei die Pulsdauer zwischen 50ns und 150fs beträgt.

12. Verfahren nach Anspruch 11, **dadurch gekennzeichnet, dass** die Pulsdauer zwischen 190fs und 10ps beträgt.

13. Verfahren nach Anspruch 11 oder 12, **dadurch gekennzeichnet, dass** die Pulsfrequenz zwischen 100kHz und 1.000kHz beträgt.

14. Verfahren nach einem der vorhergehenden Ansprüche, **dadurch gekennzeichnet, dass** die durchschnittliche Laserleistung zwischen 4 und 40W beträgt.

15. Verfahren nach Anspruch 12, **dadurch gekennzeichnet, dass** die Pulsdauer zwischen 6ns und 45ns und die Pulsfrequenz zwischen 15kHz und 200kHz beträgt.

16. Verfahren nach Anspruch 15, **dadurch gekennzeichnet, dass** die durchschnittliche Laserleistung zwischen 9 und 18W beträgt.

17. Verfahren nach einem der vorhergehenden Ansprüche, **dadurch gekennzeichnet, dass** der Strahldurchmesser des Laserstrahls im Fokus zwischen 7µm und 25µm beträgt.

## Claims

1. Method for producing a cutting tool comprising a tool body with a hard coating, wherein the hard coating (2) is applied to the tool body (1) at least in an area of a cutting edge (3), a flank face (5) and a rake face (6) comprising the following steps:
depositing a hard coating (2) on the surface of the tool body (1) of the cutting tool in the area of the cutting edge (3), a flank face (5) adjacent to the cutting edge (3) and a rake face (6) adjacent to the cutting edge (3), sharpening the cutting edge that is provided with the hard coating (2) and forming a dull rounded edge (4) by partially removing the hard coating (2) in the area of the flank face (5) of the cutting edge by laser machining, **characterized in that**
the removal of the hard coating (2) is carried out in such a way that for an angle δ between a first geometric plane (16), in which the surface (9) of the tool body (1) lying beneath the hard coating (2) of the flank face (5) extends, and a second geometric plane (18), in which a surface (8) of the hard coating (2) defined by the sharpened cutting edge (10, 14, 14a) in the area of the flank face (5) extends after removal, the following applies: 2° ≤ δ ≤ 10°, preferably 3° ≤ δ ≤ 6°,
and that during laser machining, a laser beam is aligned with its geometric beam axis (15, 15a, 30) in such a way that the geometric beam axis encloses an angle δ or an angle α + δ with the first geometric plane (16), where 1° ≤ α ≤ 10°.

2. Method according to claim 1, **characterized in that** a hard coating (2) is deposited on the tool body (1) with a layer thickness between 2 µm and 40 µm.

3. Method according to one of the preceding claims, **characterized in that** the partial removal of the hard coating (2) reduces the thickness of the hard coating (2) at the flank face (5) so that the thickness of the hard coating (2) increases from the sharpened cutting edge (10, 14, 14a). 14a) with an increasing distance from the sharpened cutting edge (10, 14, 14a).

4. Method according to one of the preceding claims, **characterized in that** the material removal of the hard coating (2) starts at the flank face (5) of the hard coating (2) in a section of the flank face (5) that is distal from the cutting edge (3) of the tool body (1) and terminates at the rake face (6) .

5. Method according to one of the preceding claims, **characterized in that** the cutting edge (10, 14, 14a) provided with the hard coating (2) is sharpened by additionally partially removing the hard coating (2) in the portion of the rake face(6) by laser machining, so an angle ε is enclosed between a third geometric plane (17), in which the surface (9) of the tool body (1) extends that is arranged under the hard coating (2) of the rake face(6) and a fourth plane (19) in which a surface (12) of the hard coating (2) defined by the sharpened cutting edge (14) extends in the area of the rake face (6) after the partial removal of the hard coating (2), wherein 0° ≤ ε ≤ 70°.

6. Method according to claim 5, **characterized in that** the hard coating (2) is removed in such a way that the following applies to the angle ε: 2° ≤ ε ≤ 10°, particularly preferably 3° ≤ ε ≤ 6° .

7. Method according to claim 5 or 6, **characterized in that**, partial removal of the hard coating (2) reduces the thickness of the hard coating (2) at the rake face (6) so that the thickness of the hard coating (2) at the rake face (6) increases from the sharpened cutting edge (14) with an increasing distance from the sharpened cutting edge (14)..

8. Method according to one of the preceding claims, **characterized in that** a diamond layer is deposited on the tool body (1) as a hard coating (2) .

9. Method according to one of the preceding claims, **characterized in that** the hard coating (2) is removed from the flank face (5) completely in sections so that the tool body (1) is exposed in sections.

10. Method according to one of the preceding claims, **characterized in that** the hard coating (2) is removed from the rake face (6) completely at least in sections so that the tool body (1) is exposed in the sections.

11. Method according to one of the preceding claims, **characterized in that** the laser machining is performed by a pulsed laser beam, wherein the pulse duration is between 50 ns and 150 fs.

12. Method according to claim 11, **characterized in that** the pulse duration is between 190 fs and 10 ps.

13. Method according to claim 11 or 12, **characterized in that** the pulse frequency is between 100 kHz and 1,000 kHz.

14. Method according to one of the preceding claims, **characterized in that** the average laser power is between 4 and 40W.

15. Method according to claim 12, **characterized in that** the pulse duration is between 6 ns and 45 ns and the pulse frequency is between 15kHz and 200kHz.

16. Method according to claim 15, **characterized in that** the average laser power is between 9 and 18 W.

17. Method according to one of the preceding claims, **characterized in that** the beam diameter of the laser beam at the focus is between 7 µm and 25 µm

## Revendications

1. Procédé de fabrication d'un outil de coupe qui présente un corps d'outil comportant un revêtement dur, dans lequel le revêtement dur (2) est appliqué sur le corps d'outil (1) au moins dans la zone d'une arête de coupe (3), d'une face de dépouille (5) et d'une face d'attaque (6), comportant les étapes de procédé consistant à:
déposer un revêtement dur (2) sur la surface du corps d'outil (1) de l'outil de coupe dans la zone de l'arête de coupe (3), d'une face de dépouille (5) adjacente à l'arête de coupe (3) et d'une face d'attaque (6) adjacente à l'arête de coupe (3),
affûter l'arête de coupe pourvue du revêtement dur (2) et formant un arrondi émoussé (4) en éliminant partiellement le revêtement dur (2) dans la zone de la face de dépouille (5) de l'arête de coupe au moyen d'un usinage au laser, **caractérisé en ce que** l'élimination du revêtement dur (2) est effectuée de telle sorte que, pour un angle δ entre un premier plan géométrique (16), dans lequel s'étend la surface (9) du corps d'outil (1) située sous le revêtement dur (2) de la face de dépouille (5), et un deuxième plan géométrique (18), dans lequel s'étend une surface (8) du revêtement dur (2) délimitée par l'arête de coupe (10, 14, 14a) affûtée dans la zone de la face de dépouille (5) après l'élimination, s'applique: 2° ≤ δ ≤ 10°, de préférence 3° ≤ δ ≤ 6°,
et **en ce que**, lors de l'usinage au laser, un faisceau laser est orienté avec son axe de faisceau géométrique (15, 15a, 30) de telle sorte que l'axe de faisceau géométrique forme, conjointement avec le premier plan géométrique (16), l'angle δ ou un angle α + δ, où 1° ≤ α ≤ 10° s'applique.

2. Procédé selon la revendication 1, **caractérisé en ce qu'**un revêtement dur (2) d'une épaisseur de couche comprise entre 2 µm et 40 µm est déposé sur le corps d'outil (1).

3. Procédé selon l'une des revendications précédentes,
**caractérisé en ce que**, lors de l'élimination partielle du revêtement dur (2), l'épaisseur du revêtement dur (2) sur la face de dépouille (5) est réduite de telle sorte que l'épaisseur du revêtement dur (2) va en augmentant en partant de l'arête de coupe (10, 14, 14a) affûtée et en s'éloignant de l'arête de coupe (10, 14, 14a) affûtée.

4. Procédé selon l'une des revendications précédentes,
**caractérisé en ce que** l'élimination de matière du revêtement dur (2) commence sur la face de dépouille (5) du revêtement dur (2) dans une section de la face de dépouille (5) éloignée de l'arête de coupe (3) du corps d'outil (1) et se termine sur la face d'attaque (6).

5. Procédé selon l'une des revendications précédentes,
**caractérisé en ce que** l'arête de coupe (10, 14, 14a) pourvue du revêtement dur (2) est affûtée par élimination partielle supplémentaire du revêtement dur (2) dans la zone de la face d'attaque (6) au moyen d'un usinage au laser de telle sorte que, après l'élimination partielle du revêtement dur (2), pour un angle ε entre un troisième plan géométrique (17), dans lequel s'étend la surface (9) du corps d'outil (1) située sous le revêtement dur (2) de la face d'attaque (6), et un quatrième plan (19), dans lequel s'étend une surface (12) du revêtement dur (2) délimitée par l'arête de coupe (14) affûtée dans la zone de la face d'attaque (6) après l'élimination, s'applique: 0° ≤ ε ≤ 70°.

6. Procédé selon la revendication 5, **caractérisé en ce que** l'élimination du revêtement dur (2) est effectuée de telle sorte que, pour l'angle ε, s'applique : 2° ≤ ε ≤ 10°, de manière particulièrement préférée 3° ≤ ε ≤ 6°.

7. Procédé selon la revendication 5 ou 6, **caractérisé en ce que**, lors de l'élimination partielle du revêtement dur (2), l'épaisseur du revêtement dur (2) sur la face d'attaque (6) est réduite de telle sorte que l'épaisseur du revêtement dur (2) sur la face d'attaque (6) va en augmentant en partant de l'arête de coupe (14) affûtée et en s'éloignant de l'arête de coupe (14) affûtée.

8. Procédé selon l'une des revendications précédentes,
**caractérisé en ce qu'**une couche de diamant est déposée sur le corps d'outil (1) en tant que revêtement dur (2).

9. Procédé selon l'une des revendications précédentes,
**caractérisé en ce que** le revêtement dur (2) est complètement ôté dans certaines sections de la face de dépouille (5) de telle sorte que le corps d'outil (1) est libéré dans la section concernée.

10. Procédé selon l'une des revendications précédentes,
**caractérisé en ce que** le revêtement dur (2) est complètement ôté dans certaines sections de la face d'attaque (6) de telle sorte que le corps d'outil (1) est libéré dans la section concernée.

11. Procédé selon l'une des revendications précédentes,
**caractérisé en ce que** l'usinage au laser est effectué avec un faisceau laser pulsé, dans lequel la durée d'impulsion est comprise entre 50 ns et 150 fs.

12. Procédé selon la revendication 11, **caractérisé en ce que** la durée d'impulsion est comprise entre 190 fs et 10 ps.

13. Procédé selon la revendication 11 ou 12, **caractérisé en ce que** la fréquence d'impulsion est comprise entre 100 kHz et 1000 kHz.

14. Procédé selon l'une des revendications précédentes,
**caractérisé en ce que** la puissance laser moyenne est comprise entre 4 et 40 W.

15. Procédé selon la revendication 12, **caractérisé en ce que** la durée d'impulsion est comprise entre 6 ns et 45 ns et la fréquence d'impulsion est comprise entre 15 kHz et 200 kHz.

16. Procédé selon la revendication 15, **caractérisé en ce que** la puissance laser moyenne est comprise entre 9 et 18 W.

17. Procédé selon l'une des revendications précédentes,
**caractérisé en ce que** le diamètre de faisceau du faisceau laser dans le foyer est compris entre 7 µm et 25 µm.
